# EUROPEAN PATENT APPLICATION

(11) **EP 4 765 640 A1**
(43) Date of publication of application: **24.06.2026**
(21) Application number: 25214761.6
(22) Date of filing: 10.11.2025
(51) Int. Cl.: H03K 17/082

(54) **A METHOD AND CIRCUIT ARRANGEMENT FOR VOLTAGE PROTECTION**

(30) Priority: 18.12.2024 US 202418985655
(71) Applicant: Analog Devices International Unlimited Company, Co. Limerick (IE)
(72) Inventor: Aherne, David, Limerick (IE)
(74) Representative: Horler, Philip John

(57) **Abstract**

A method and circuit arrangement for voltage protection is disclosed. In certain embodiments, a controllable switch comprises a control terminal, a first channel terminal, and a second channel terminal, and arranged to be switched between an off-state and an on-state. In the on-state the controllable switch allows a current to flow between the first channel terminal and the second channel terminal. An overvoltage protection circuit is configured to determine a voltage difference between a first voltage of the first channel terminal and a second voltage of the second channel terminal. The overvoltage protection circuit also sets a control signal to a protection value to operate the controllable switch in the off-state in response to determining that the voltage difference is greater than or equal to a switch threshold.

## Description

### FIELD

This application relates to switching of a semiconductor switch (i.e. a solid state switch). Specifically, preventing a semiconductor switch from switching in response to a voltage differential across the terminals of the semiconductor switch.

### BACKGROUND

Solid state switches may be used with components such as, a precision measurement apparatus, and high voltage automated test equipment. A solid state switch may be designed to block large voltages in its off-state, but such voltages may cause damage to a solid state switch if the solid state switch were to be operated in its on-state. For example, damage may be caused to a solid state switch if it is operated to switch from its off-state to its on-state, when blocking a large voltage differential in its off-state.

### SUMMARY OF THE DISCLOSURE

The present disclosure provides a solid state switch with voltage dependent switching. Such solid state switches are suitable for use with precision measurement apparatuses and high voltage automated test equipment.

According to a first aspect there is provided a solid state switch device, comprising:
a controllable switch comprising a control terminal, a first channel terminal, and a second channel terminal, and arranged to be switched between an off-state and an on-state, wherein in the on-state the switch allows a current to flow between the first channel terminal and the second channel terminal; and
an overvoltage protection circuit configured to:
   determine a voltage difference between a first voltage of the first channel terminal and a second voltage of the second channel terminal; and,
   setting a control signal to a protection value to operate the controllable switch in the off-state in response to determining that the voltage difference is greater than or equal to a switch threshold.

The switch threshold may be equal to (or equal to 90% of) the rated breakdown voltage of the controllable switch. The switch threshold may be different to the threshold voltage Vt (commonly also abbreviated as Vₜₕ or V_{GS(th)}) of a FET (e.g., the first FET, and optionally the second FET) of the controllable switch. The switch threshold may be greater than the threshold voltage of a FET of the controllable switch. The switch threshold may be greater than the cut-off voltage of the controllable switch (at least 2 times greater). The term 'switch' in the feature 'switch threshold' is merely a label and therefore the feature 'switch threshold' may be called 'threshold' or 'first threshold'.

Optionally, the solid state switch device is configured to use the control signal to, when the voltage difference is greater than or equal to a switch threshold: prevent the controllable switch from switching to the on-state from the off-state of the controllable switch; and/or, control the controllable switch to switch to the off-state from the on-state of the controllable switch.

Optionally, the overvoltage protection circuit is configured to receive an instruction signal for controlling the state of the controllable switch to either an off-state or an on-state. Optionally, the overvoltage protection circuit is configured to, in response to determining that the voltage difference is less than the switch threshold, set the control signal to a pass value, such that when the control signal is a pass value the instruction signal controls the state of the controllable switch.

Optionally, the overvoltage protection circuit comprises a first buffer comprising an input and an output, wherein the input is electrically coupled to the first channel terminal. Optionally, the overvoltage protection circuit comprises a second buffer comprising an input and an output, wherein the input is electrically coupled to the second channel terminal.

Optionally, the first buffer is a unity gain buffer (UGB), a voltage follower, a cascade complementary source follower, or a two-transistor buffer. Optionally, the second buffer is a unity gain buffer (UGB), a voltage follower, a cascade complementary source follower, or a two-transistor buffer.

The controllable switch may be a GaN FET, SiC FET, JFET, FET, MOSFET, DMOS, or a Lateral Double-Diffusion MOSFET (LDMOS).

Optionally, the overvoltage protection circuit is arranged to generate a difference signal based on the output of the first buffer and the output of the second buffer. Optionally, the voltage difference is compared to the switch threshold by comparing the difference signal to a comparison threshold. Optionally, the comparison threshold has a predetermined relationship to the switch threshold.

Optionally, the difference signal is a current signal.

Optionally, the difference signal is proportional to the voltage difference between the first channel terminal and the second channel terminal.

Optionally, the overvoltage protection circuit further comprises a resistive component. Optionally, the output of the first buffer is coupled to a first terminal of the resistive component. Optionally, the output of the second buffer is coupled to a second terminal of the resistive component.

Optionally, the resistive component is a resistor. Optionally, the output voltage of the first buffer is proportional to the input voltage of the first buffer. Optionally, the output voltage of the second buffer is proportional to the input voltage of the second buffer.

Optionally, the overvoltage protection circuit comprises a first current mirror arrangement configured to: generate the difference signal based on the current flow between the output of the first buffer and the output of the second buffer.

Optionally, the first current mirror arrangement is arranged to have a gain less than or equal to unity gain.

Optionally, the first current mirror arrangement comprises a first current mirror component and a second current mirror component. Optionally, the first current mirror component is positioned between the output of the first buffer and the resistive component. Optionally, the second current mirror component is arranged to generate the difference signal based on the current flow through the first current mirror component.

Optionally, the second current mirror arrangement is arranged to have a gain less than unity gain.

Optionally, the solid state switch device is a bi-directional solid state switch. Optionally, the first current mirror arrangement is configured to generate the difference signal if a voltage at the first channel terminal is greater than the voltage at the second channel terminal. Optionally, the overvoltage protection circuit further comprises a second current mirror arrangement configured to generate the difference signal if a voltage at the second channel terminal is greater than the voltage at the first channel terminal.

Optionally, the second current mirror arrangement comprises a third current mirror component and a fourth current mirror component. Optionally, the third current mirror component is positioned between the output of the second buffer and the resistive component.

Optionally, the fourth current mirror component is arranged to generate the difference signal based on the current flow through the third current mirror component.

Optionally, the difference signal is a voltage signal.

Optionally, the overvoltage protection circuit further comprises a first level shifter circuit arranged to reduce the dynamic range of the first voltage of the first channel terminal within a first voltage range to generate a first voltage output. Optionally, the overvoltage protection circuit further comprises a second level shifter circuit arranged to reduce the dynamic range of the second voltage of the second channel terminal within the first voltage range to generate a second voltage output. Optionally, the overvoltage protection circuit is arranged to generate the difference signal based on the first voltage output and the second voltage output.

Optionally, the controllable switch comprises a first Field Effect Transistor, FET. Optionally, the control terminal comprises a gate terminal of the first FET. Optionally, the first channel terminal comprises a drain terminal of the first FET.

Optionally, the controllable switch further comprises a second FET. Optionally, a source terminal of the first FET is coupled to a source terminal of the second FET. Optionally, the control terminal of the controllable switch further comprises a gate terminal of the second FET. Optionally, the second channel terminal comprises a drain terminal of the second FET.

According to a second aspect there is provided an overvoltage protection circuit configured to be coupled to: a control terminal of a controllable switch; a first channel terminal of the controllable switch; and a second channel terminal of the controllable switch, wherein the overvoltage protection circuit configured to:
determine a voltage difference between the first channel terminal and the second channel terminal; and,
generate a control signal for setting the controllable switch to operate in the off-state, in response to determining that the voltage difference is greater than or equal to a switch threshold.

Optional features of the first aspect may be applied to the second aspect.

According to a third aspect there is provided a method of operating a controllable switch for overvoltage protection, the controllable switch comprising a control terminal, a first channel terminal, and a second channel terminal, and arranged to be switched between an off-state and an on-state, wherein in the on-state the switch allows a current to flow between the first channel terminal and the second channel terminal, the method comprising:
determining a voltage difference between a first voltage of the first channel terminal and a second voltage of the second channel terminal;
determining that the voltage difference is greater than or equal to a switch threshold; and,
operate the controllable switch in the off-state in response to determining that the voltage difference is greater than or equal to a switch threshold.

Optionally, when the voltage difference is greater than or equal to a switch threshold, preventing the controllable switch from switching to the on-state from the off-state of the controllable switch. Optionally, when the voltage difference is greater than or equal to a switch threshold, controlling the controllable switch to switch to the off-state from the on-state of the controllable switch.

Optionally, the method of the third aspect receives an instruction signal for controlling the state of the controllable switch to either an off-state or an on-state. Optionally, when the voltage difference is less than the switch threshold, controlling the state of the controllable switch to either an off-state or an on-state in accordance with the instruction signal.

Optional features of the first aspect may be applied to the third aspect.

### BRIEF DESCRIPTION OF THE DRAWINGS

Figure 1a illustrates a design of a NLDMOS switch.
Figure 1b illustrates a bi-directional NLDMOS switch comprising a first NLDMOS and a second NLDMOS in series.
Figure 1c illustrates a design of a GaN switch.
Figure 2 illustrates a schematic block wiring diagram of a solid state switch comprising a controllable switch and a overvoltage protection circuit.
Figure 3 illustrates a schematic block wiring diagram of a first unidirectional overvoltage protection circuit, with optional features.
Figure 4 illustrates a schematic block wiring diagram of a first bi-directional overvoltage protection circuit, with optional features.
Figure 5a illustrates a schematic block wiring diagram of an overvoltage protection circuit, with optional features.
Figure 5b illustrates an example of a schematic block wiring diagram of the overvoltage protection circuit of Figure 5a, with optional features.
Figure 6 illustrates a process to protect a controllable switch from large voltages.
Figure 7 illustrates a schematic block wiring diagram of circuit to compare a difference signal to a comparison threshold and generate a control signal.

### DETAILED DESCRIPTION OF EMBODIMENTS

A controllable switch, such as a Field Effect Transistor, FET, when configured to function as a switch may be damaged by large channel voltages. For example, many FET devices may be characterised by their "blocking voltage" or "drain source breakdown voltage" which is the absolute maximum voltage rating which a FET may handle between its channel terminals (e.g., drain and source terminals) before the FET enters the breakdown region and be permanently damaged. A FET device may be damaged when switched to its on-state from its off-state, if the FET device is arranged with a large voltage differential between its channel terminals. In some scenarios the voltage between a FET device's channel terminals may be even higher than the rated breakdown voltage for a short period of time, due to a voltage transient. This may not in itself damage a FET device, but switching the FET device to its on-state during these voltage transients (e.g., above the rated breakdown voltage) may damage the FET device. These voltage transients may be more likely to occur when the FET device is used with precision measurement apparatuses and high voltage automated test equipment. In addition, a large voltage differential between channel terminals of a controllable switch, when switched to its on-state, will cause a large current to flow, and thus the controllable switch must dissipate power (and thus heat via resistive heating), which may lead to damage. In addition, some controllable switches may have a safe operating area restriction (such as, DMOS switches), therefore a large voltage differential between its channel terminals when the controllable switch is in its on-state may cause degradation over time and thus reduce the operating life of the controllable switch. Additional circuitry may be used to prevent damage to the FET device in the above described cases.

Many types of controllable switches such as may types of FETs (e.g., GaN FETs, SiC FETs, JFETs, Metal Oxide Silicon FETs (MOSFETs or called MOSs), Diffusion MOSs (DMOSs), Lateral DMOSs (LDMOSs), vertical DMOSs (VDMOSs), etc.) can benefit from the additional circuitry. For example, the controllable switches described below may be LDMOS devices configured to function as switches. In addition, the LDMOS devices may be lateral doubly diffused MOS devices. A DMOS device may imply a high-voltage device. For example, greater than 5V, or, greater than/equal to 10V, can be high-voltage.

As a brief non-limiting overview of an embodiment of the invention, a new solid state switch device suitable for use in/with high voltage precision instruments is provided. The new solid state switch device can block high voltages when switched-off, and not be damaged if a control signal is generated to turn-on the solid state switch. The new solid state switch device can comprise a controllable switch and an overvoltage protection circuit configured to operate the controllable switch in the off-state in response to comparing the voltage difference to a switch threshold.

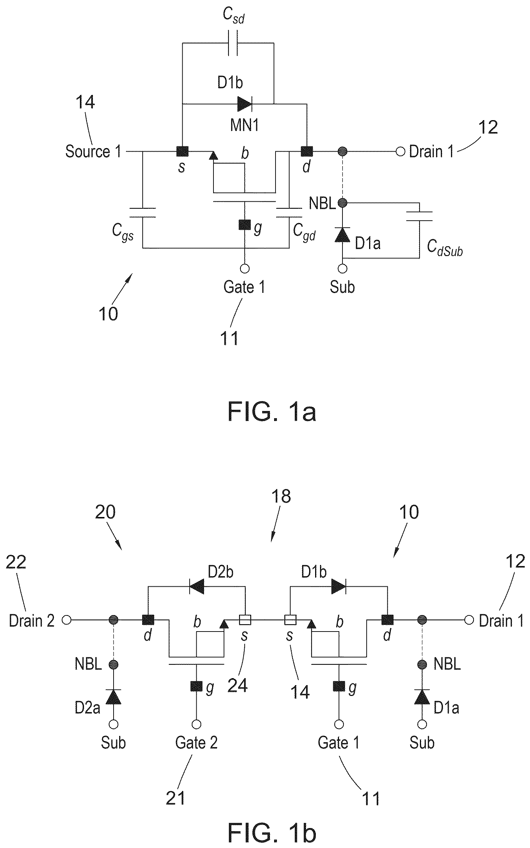

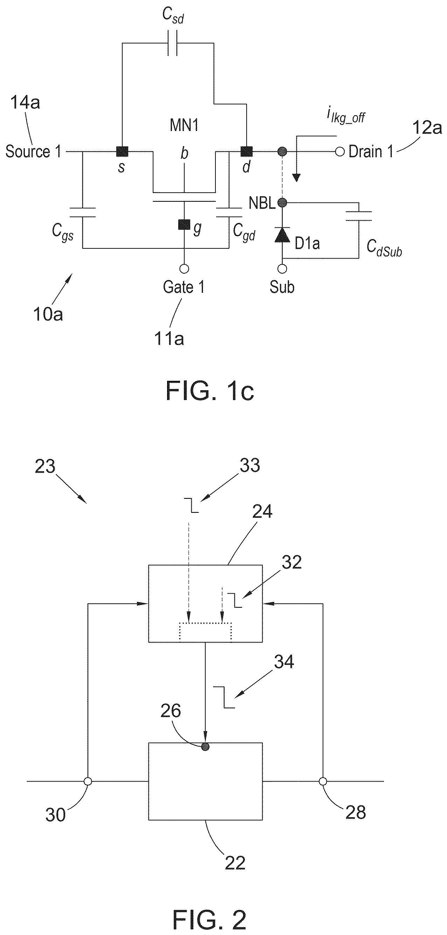

Figures 1a, 1b, and 1c each show examples of a controllable switch 10, 18, 10a.

Figure 1a shows an n-type LDMOS 10 (i.e., NLDMOS 10) with its parasitic diodes D1a and D1b. The parasitic diodes D1a and D1b of the NLDMOS 10 result from the fabrication process and are present in some types of DMOS switches. The parasitic diode D1a (between the substrate and an isolation layer, e.g. an N-type buried layer (NBL)) of the NLDMOS 10 may also be present in MOSFET switches.

NLDMOS 10 comprises a gate terminal 11, a drain terminal 12, and a source terminal 14. D1a is formed between the substrate and the isolation layer, such as an NBL in Figure 1a. The NBL is coupled to a NBL terminal, which may be accessible to a circuit designer. The NBL terminal may typically be shorted to the drain terminal 12 for normal operation, which may reduce noise from the substrate. This may be achieved by externally coupling the NBL terminal to the drain terminal 12 or may be achieved by an internal connection of the NBL to the drain. D1b is formed between the source and drain of the NLDMOS 10. The parasitic diodes D1a and D1b are formed between P-type and N-type material of the NLDMOS 10.

A P-type LDMOS (PLDMOS) (or other p-type MOS switch) could be described similarly.

LDMOS devices are suitable for use in high voltage applications and may have source and channel regions formed using a double diffusion process. As a result of the fabrication process, the NLDMOS 10 is a uni-directional solid state switch and the parasitic diodes D1a and D1b are formed between high voltage P-type and N-type material. For example, when gate terminal 11 of the (uni-directional) NLDMOS switch 10 receives an 'OFF' signal, current may still flow from source terminal 14 to drain terminal 12 via the (forward biased) parasitic diode D1b.

Figure 1b shows a bi-directional NLDMOS switch 18 comprising a first NLDMOS 10 and a second NLDMOS 20 in series. The second NLDMOS 20 comprises a gate terminal 21, a drain terminal 22, and a source terminal 24. The second NLDMOS 20 can be identical to the first NLDMOS 10. The source terminal 14 of the first NLDMOS 10 is coupled to a source terminal 24 of the second NLDMOS 20. The bi-directional NLDMOS switch 18 is arranged to, when in its off-state, block current flow in both directions: from the drain terminal 22 of the second NLDMOS 20 to the drain terminal 12 of the first NLDMOS 10; and from the drain terminal 12 of the first NLDMOS 10 to the drain terminal 22 of the second NLDMOS 20. The first and second LDMOSs 10, 20 may be switched to the off-states if the gate-source voltage (Vgs) (between the gate terminals 11, 21 of the first and second LDMOSs 10, 20 and the source terminals 14, 24) is less than the threshold voltage Vt, e.g., 0V. For example, the first and second LDMOSs 10, 20 may be switched to the off-state by coupling gate terminals 11, 21 to source terminals 14, 24, or, by coupling both gate terminals 11, 21 and source terminals 14, 24 to the substrate (i.e., 0V).

If the voltage at the drain terminal 22 of the second NLDMOS 20 is greater than the voltage at the drain terminal 12 of the first NLDMOS 10, when both of the first and second NLDMOSs 10, 20 are in their on-state, then the first and second NLDMOSs 10, 20 can allow current to flow from the drain terminal 22 of the second NLDMOS 20 to the drain terminal 12 of the first NLDMOS 12. When both of the first and second NLDMOSs 10, 20 are in their off-state, the second NLDMOS 20 blocks current flow from the drain terminal 22 to the source terminal 24 of the second NLDMOS 20 because no channel is formed by the second NLDMOS 20 and a parasitic diode D2b of the second NLDMOS 20 is reverse biased.

Figure 1c shows an n-type GaN 10a with its parasitic diode D1a. The parasitic diode D1a of the GaN 10a results from the fabrication process and may be present in some types of GaN switches. The parasitic diode D1a (between the substrate and an isolation layer, e.g. an N-type buried layer (NBL)) of the GaN 10a may also be present in other FET switches.

The GaN 10a comprises a gate terminal 11a, a drain terminal 12a, and a source terminal 14a. D1a is formed between the substrate and the isolation layer, such as an NBL in Figure 1c. The NBL is coupled to a NBL terminal, which may be accessible to a circuit designer. The NBL terminal may be shorted to the drain terminal 12a or source terminal 14a for normal operation, which may reduce noise from the substrate. This may be achieved by externally coupling the NBL terminal to the drain terminal 12a or source terminal 14a, or, by an internal connection of the NBL to the drain or source. The parasitic diode D1a is formed between P-type and N-type material of the GaN 10a.

Figure 1c shows a GaN 10a with the parasitic drain-substrate capacitor (C_{dsub}), a parasitic source-drain capacitor (C_{sd}), a parasitic gate-source capacitor (C_{gs}), and a parasitic gate-drain capacitor (C_{gd}). The parasitic components shown in Figure 1c are the dominant parasitic components when the GaN 10a is switched to its off-state and the voltage at the drain 12a is greater than the voltage at the source 14a.

A P-type GaN (or other p-type FET switch) could be described similarly.

GaN devices are suitable for use in high voltage applications. As a result of the fabrication process, the GaN 10a is a solid state switch and the parasitic diodes D1a is formed between high voltage P-type and N-type material.

Although the controllable switches 10, 18, 10a in Figures 1a, 1b, 1c are shown with NBL terminals, NBL terminals are optional. For example, isolated controllable switches may not comprise NBL terminals.

Figure 2 shows a solid state switch device 23, comprising a overvoltage protection circuit 24, and a controllable switch 25 (for example, NLDMOS 10 of Figure 1a, bi-directional NLDMOS switch 18 of Figure 1b, GaN 10a of Figure 1c). The controllable switch 25 comprises a control terminal 26 (e.g., 11, 21, 11a), a first channel terminal 28 (e.g., 12, 12a), and a second channel terminal 30 (e.g., 14, 22, 14a). The controllable switch 25 is arranged to be switched between an off-state and an on-state based on a control signal 32 and/or an instruction signal 33. The output of the overvoltage protection circuit 24 is coupled to the control terminal 26 of the controllable switch 25. The on-state the controllable switch 23 allows a current to flow between the first channel terminal 28 and the second channel terminal 30.

The overvoltage protection circuit 24 is configured to determine a voltage difference between a first voltage of the first channel terminal 28 and a second voltage of the second channel terminal 30. The voltage difference is compared to a switch threshold, and the overvoltage protection circuit 24 may only allow the controllable switch 25 to be switched between its on-state and off-state in response to the comparison.

In an example, the overvoltage protection circuit 24 may generate an output signal 34 which operates the controllable switch 25 in the off-state of the controllable switch 25. The controllable switch 25 may be operated in response to comparing the voltage difference to the switch threshold.

The overvoltage protection circuit 24 is configured to set a control signal 32 to a protection value or a pass value. The overvoltage protection circuit may be configured to receive an instruction signal 33 for controlling the state of the controllable switch 25 to either an off-state or an on-state.

In response to determining that the voltage difference between the first channel terminal 28 and the second channel terminal 30 is less than the switch threshold, the overvoltage protection circuit 24 may set the control signal 32 to a pass value. When the control signal 32 is a pass value, the instruction signal 33 is configured to control the state of the controllable switch 25. For example, if the instruction signal 33 instructs the controllable switch 25 to be in an off-state, then the output signal 34 of the overvoltage protection circuit 24 may operate the controllable switch 25 to the off-state. In another example, if the instruction signal 33 instructs the controllable switch 25 to be in an on-state, then the output signal 34 from the overvoltage protection circuit 24 may operate the controllable switch 25 to the on-state. Thus, the instruction signal 33 may be used to determine that the output signal 34 from the overvoltage protection circuit 24 is generated and/or applied to the control terminal 26 of the controllable switch 25.

In response to determining that the voltage difference between the first channel terminal 28 and the second channel terminal 30 is greater than or equal to the switch threshold, the overvoltage protection circuit 24 may set the control signal 32 to a protection value. When the control signal 32 is set to the protection value, the overvoltage protection circuit 24 may be configured to prevent the controllable switch 25 from switching to the on-state from the off-state. When the control signal 32 is set to the protection value, the overvoltage protection circuit 24 may be configured to control the controllable switch 25 to switch to the off-state from the on-state.

If the controllable switch 25 is in an off-state, then, using the control signal 32, the overvoltage protection circuit 24 may be configured to prevent the controllable switch 25 from switching from the off-state to the on-state in response to determining that the voltage difference is greater than or equal to the switch threshold. If the controllable switch 25 is in an on-state, then using the control signal 32, the overvoltage protection circuit 24 may be configured to control the controllable switch 25 to switch from the on-state to the off-state in response to determining that the voltage difference is greater than or equal to the switch threshold. The overvoltage protection circuit 24 is configured to generate the output signal 34 to operate the controllable switch 25 in the off-state in response to determining that the voltage difference is greater than or equal to the switch threshold.

That is, in an example, the overvoltage protection circuit 24 may be configured to receive an instruction signal 33 and pass the instruction signal 33 to the control terminal 26 of the controllable switch 25 in response to determining that the voltage difference is less than the switch threshold. Thus, in this example, the instruction signal 33 may be the output signal 34. In addition, the overvoltage protection circuit 24 may block the instruction signal 33 to the controllable switch 25 in response to determining that the voltage difference is greater than or equal to the switch threshold (to ensure that the controllable switch 25 is in its off-state).

The switch threshold may be equal to (or equal to substantially 90% of) the rated breakdown voltage of the controllable switch 25. The switch threshold may be based on the safe operating area (SOA) of the controllable switch. Each controllable switch may be characterised by a data sheet which includes an SOA plot. The switch threshold may be based on the power dissipation rating of the controllable switch or a thermal system comprising the controllable switch. Depending on the package and thermal system comprising the controllable switch, a switch threshold based on the power dissipation rating may be used to restrict / protect against excessive power.

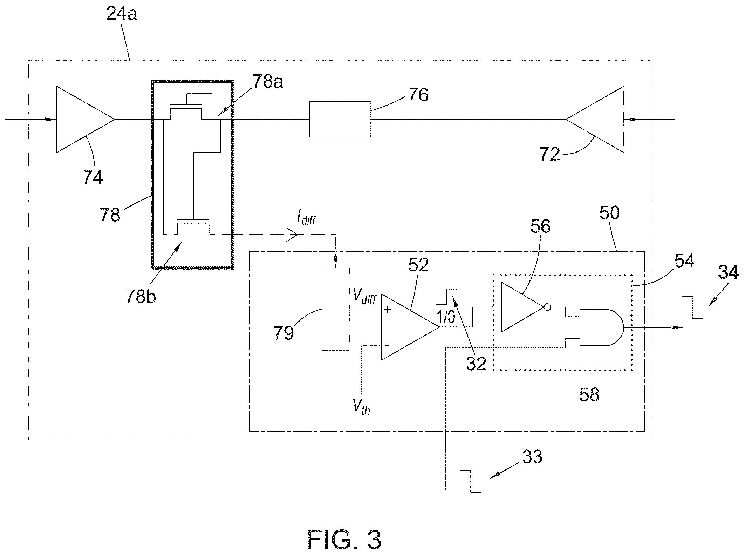

Figure 3 shows an overvoltage protection circuit 24a. The overvoltage protection circuit 24a further comprises a first buffer 72, a second buffer 74, and a resistive element 76, e.g., a resistor.

The first buffer 72 comprises an input and an output. The input of the first buffer 72 is electrically coupled to the first channel terminal 28. The first buffer 72 is configured to detect a first voltage at the first channel terminal 28 and apply a first buffer voltage to a first terminal of the resistive element 76. The first buffer voltage may be proportional to the first voltage. The second buffer 74 comprises an input and an output. The input of the second buffer 74 is electrically coupled to the second channel terminal 30. The second buffer 74 may be configured to detect a second voltage at the second channel terminal 30 and apply a second buffer voltage to a second terminal of the resistive element 76. The second buffer voltage may be proportional to the second voltage.

In an alternative example, the overvoltage protection circuit 24a may be configured to detect a first voltage at the first channel terminal 28 with respect to a voltage reference, detect a second voltage at the second channel terminal 30 with respect to the voltage reference, and generate the difference signal based on the first and second voltage.

Each of the first and second buffers 72, 74 may be at least one of unity gain buffer (UGB), a voltage follower, a cascade complementary source follower, and/or a two-transistor buffer. Preferably, the output of each of the first and second buffers 72, 74 acts as a current source and/or current sink.

In an example, the first buffer voltage is equal to the first voltage, and the second buffer voltage is equal to the second voltage. Thus, the voltage across the resistive element 76 is equal to the voltage across the controllable switch 25. Therefore, the overvoltage protection circuit 24a may be arranged to generate a difference signal based on the output of the first buffer 72 and the output of the second buffer 74. The difference signal may be a current signal flowing through the resistive element 76 and between the first and second buffers 72, 74. In an example, the voltage at the output of the second buffer 74 is greater than the voltage at the output of the first buffer 72, such that the conventional current is sourced by the second buffer 74, and the first buffer 72 sinks the current. Thus, the current signal may be equal to the voltage difference divided by the resistance of the resistive element 76. In the example of Figure 3, the difference signal is detected via a current mirror 78 (although other detection means may be used).

The voltage difference between the first and second channel terminals 28, 30, may be compared to the switch threshold indirectly, for example, by comparing the difference signal (*I_{diff}*, or *V_{diff}*) to a comparison threshold (e.g., *Vₜₕ*)*.* The comparison threshold may have a predetermined relationship to the switch threshold.

The overvoltage protection circuit 24 may further comprise a first current mirror arrangement 78.

The first current mirror arrangement 78 is arranged to generate a current signal based on the current flow between the output of the first buffer 72 and the output of the second buffer 74. The first current mirror arrangement 78 is configured to generate a current difference signal (*I_{diff}*) based on the current flowing through the resistive element 76.

The first current mirror arrangement 78 may be arranged to have a gain equal to unity gain. The first current mirror may be provided such that the current difference signal (*I_{diff}*) is a substantially equal to the current flowing through the resistive element 76. Thus, the current difference signal (*I_{diff}*) may be proportional to the voltage difference across the controllable switch 25. Alternatively, the first current mirror arrangement 78 may be arranged to have a gain less than unity gain.

As shown in Figure 3, the first current mirror arrangement 78 comprises a first current mirror component 78a and a second current mirror component 78b. The first current mirror component 78a is positioned between the output of the second buffer 74 and the resistive component 76. The second current mirror component 78b is arranged to generate the current signal based on the current flow through the first current mirror component 78a. Alternatively, the first current mirror arrangement 78 may comprise any current mirror.

Figure 3 shows an example sub-circuit 50 which receives the difference signal (*I_{diff}*) to set the control signal 32. As shown, the sub-circuit 50 also receives the instruction signal 33. The sub-circuit 50 may be arranged to generate the output signal 34 based on the control signal 32 and the instruction signal 33. However, it will be understood that the sub-circuit 50 is one of many alternatives which may be apparent to the skilled person.

Optionally, the difference signal represented as a current (*I_{diff}*) may be converted to a voltage (*V_{diff}*) for the comparison, by optional converter 79 (e.g., a resistor, or resistive element).

In an example, the difference signal may be provided to a comparator 52 and compared to the comparison threshold (*Vₜₕ*)*.* The output of the comparator 52 may be input into a logic circuit 54 to allow or block the instruction signal 33 to the controllable switch 25. In an example, the logic circuit 54 may comprise a logic inverter 56 and a AND-gate 58 to generate the output signal 34.

When the difference signal (*V_{diff}*) is less than comparison threshold (*Vₜₕ*)*,* the output of the comparator 52 (e.g., the control signal 32) is a 'logic 0' (e.g., the pass value), and the output of the logic inverter 56 is a 'logic 1'. Thus, due to the AND-gate 58, the output signal 34 is a "logic 0' if the instruction signal 33 is also a "logic 0', and the output signal 34 is a 'logic 1' if the instruction signal 33 is also a "logic 1'. In contrast, when the difference signal (*V_{diff}*) is greater than comparison threshold (*Vₜₕ*)*,* the output of the comparator 52 (e.g., the control signal 32) is a 'logic 1' (e.g., the protection value), and the output of the logic inverter is a 'logic 0'. Thus, due to the AND-gate 58, the output signal 34 will be a 'logic 0' if the instruction signal 33 is a 'logic 1' or a 'logic 0'.

Alternatively, the difference signal may be provided to a processor which may generate (or not generate) the control signal 32 and/or the output signal 34 based on the difference signal.

In an example, the resistive element 76 is a resistor. In alternative examples, it may be a depletion mode FET (e.g., JFET), or any resistive component. The value of the resistive element 76 may be predetermined to produce a current proportional to the switch threshold.

In an example, the switch threshold may be 90V, the voltage difference may be 80V, the resistive element 76 may be 10K Ohms, and therefore the difference signal (*I_{diff}*) may be 8mA (assuming a unity gain current mirror 78). The comparison threshold may be 9mA, and thus have a predetermined relationship to the [90V] switch threshold, (i.e., the relationship is proportional and based on the value of the resistive element 76, and optionally on the gain of the current mirror 78).

The overvoltage protection circuit 24a of Figure 3 is an example of a uni-directional overvoltage protection circuit, which may only generate a current difference signal (*I_{diff}*) if the voltage at the second channel terminal 30 is greater than the voltage at the first channel terminal 28. Alternatively, the first current mirror arrangement 78 may be positioned between the output of the first buffer 72 and the resistive component 76, if the overvoltage protection circuit 24a is arranged to determine if the voltage at the first channel terminal 28 is greater than the second channel terminal 30, and exceeds the switch threshold.

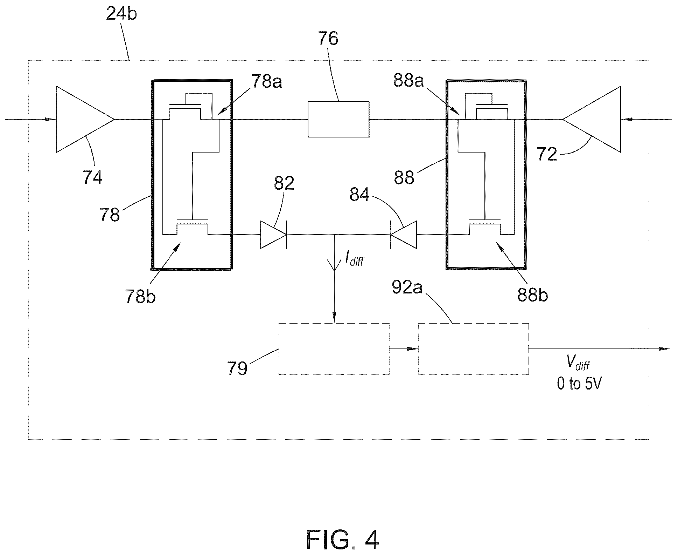

Figure 4 shows an overvoltage protection circuit 24b. The overvoltage protection circuit 24b of Figure 4 shows all of the features of the overvoltage protection circuit 24a of Figure 3, in addition to certain optional features. The same reference numerals are used to denote the same/corresponding features in relation to Figure 3 and will not be described in detail again below. The overvoltage protection circuit 24b is an alternative circuit to the overvoltage protection circuit 24a shown in Figure 3. The first buffer 72 is configured to be couplable to the first channel terminal 28 and receive the corresponding voltage. The second buffer 74 is configured to be couplable to the second channel terminal 30 and receive the corresponding voltage.

The solid state switch device 23 may be a bi-directional solid state switch. The bi-directional solid state switch may comprise the bi-directional overvoltage protection circuit 24b. The first current mirror arrangement 78 is configured to generate the current signal (*I_{diff}*) if a voltage at the second channel terminal 30 is greater than the voltage at the first channel terminal 28. The bi-directional overvoltage protection circuit 24b further comprises a second current mirror arrangement 88 configured to generate the current signal (*I_{diff}*) if a voltage at the first channel terminal 28 is greater than the voltage at the second channel terminal 30 of the controllable switch 25. First and second diodes 82, 84 are shown to prevent the current signal (*I_{diff}*) (generated via one of the current mirror arrangements 78, 88) from flowing into the other of the current mirror arrangements 88, 78, and instead to a current-voltage converter 79. As shown in Figure 4, the output of the current-voltage converter 79 is electrically coupled to the input of an optional level shifter 92 to generate a difference signal (*V_{diff}*) between a voltage range (e.g., 0 to 5V) which may be compared to the comparison threshold (*Vₜₕ*)*.*

The second current mirror arrangement 88 may be substantially similar to the first current mirror arrangement 78, or it may be different. In an example, the second current mirror arrangement 88 may comprise a third current mirror component 88a and a fourth current mirror component 88b, wherein the third current mirror component 88a is positioned between the output of the first buffer 72 and the resistive component 76. The fourth current mirror component 88b is arranged to generate the current signal (*I_{diff}*) based on the current flow through the third current mirror component 88a.

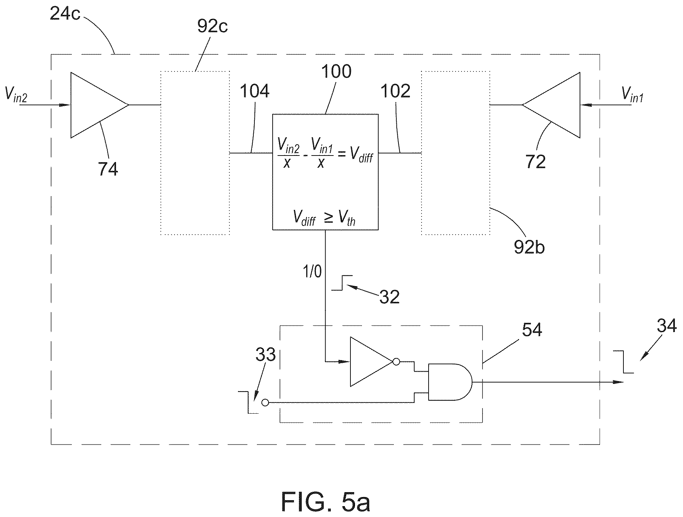

Figure 5a shows an overvoltage protection circuit 24c. The overvoltage protection circuit 24c of Figure 5a shows some of the features of the overvoltage protection circuit 24a of Figure 3, in addition to certain optional features. The same reference numerals are used to denote the same/corresponding features in relation to Figure 3 and will not be described in detail again below. The overvoltage protection circuit 24c is an alternative circuit to the overvoltage protection circuits 24a, 24b shown in Figures 3, 4.

Figure 5a shows the overvoltage protection circuit 24c arranged to generate the control signal 32 configured to stop applying the instruction signal 33 in response to determining that the voltage difference between the first and second channel terminals 28, 30 is greater than or equal to the switch threshold, corresponding to *V_{diff}* ≥ *Vₜₕ*.

The overvoltage protection circuit 24c comprises the first buffer 72, the second buffer 74, and a difference and threshold circuit 100. The difference and threshold circuit 100 is arranged to determine the difference between the inputs 102, 104, and then compare the difference to the difference threshold voltage to generate the control signal 32 (i.e., a binary output, suitable for inputting into the logic circuit 54). The control signal 32 may be used to prevent the instruction signal 33 in response to determining that the voltage difference between the first and second channel terminals 28, 30 is greater than or equal to than the switch threshold, for example, via logic circuit 54. Optionally, as shown in Figure 5a, the overvoltage protection circuit 24c further comprises a first and second level shifter circuits 92b, 92c to reduce the voltages generated by the buffers 72, 74, to the low voltage domain (i.e., 0 to 5V). Advantageously, this enables the components of the difference and threshold circuit 100 to use low voltage (5V) components.

The first level shifter circuit 92b may be arranged to reduce the dynamic range of the first voltage of the first channel terminal within a first voltage range to generate a first voltage output 102. The second level shifter 92c circuit arranged to reduce the dynamic range of the second voltage of the second channel terminal within the first voltage range to generate a second voltage output 104.

In an alternative example, without the first and second level shifter circuits 92b, 92c the inputs 102, 104 to the difference and threshold circuit 100 may be substantially equal to the first voltage at the first channel terminal 28, and the second voltage at the second channel terminal 30, respectively.

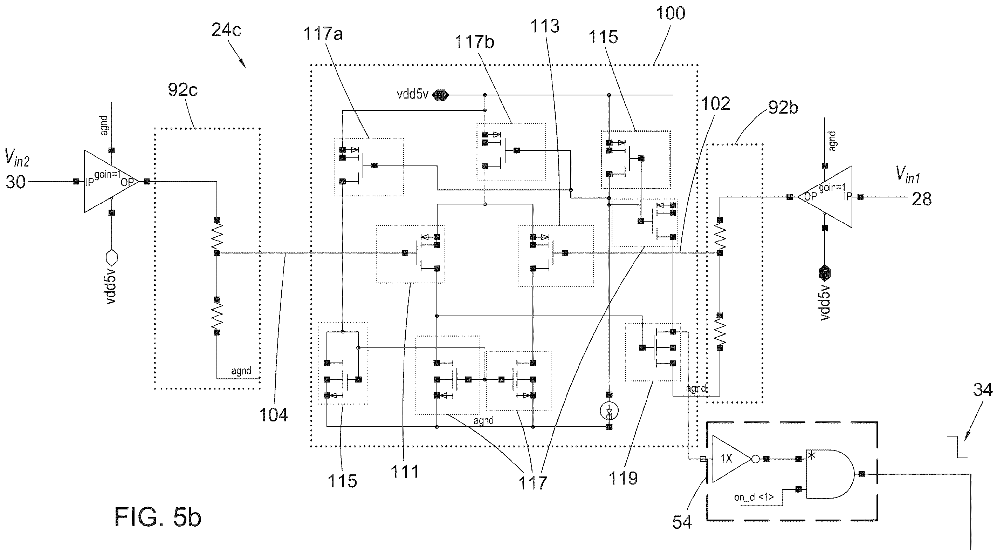

Figure 5b shows an example of the overvoltage protection circuit 24c of Figure 5a. The overvoltage protection circuit 24c of Figure 5b shows all of the features of the overvoltage protection circuit 24c of Figure 5a, in addition to certain optional features. The same reference numerals are used to denote the same/corresponding features in relation to Figure 5a and will not be described in detail again below.

The overvoltage protection circuit 24c of Figure 5b shows the first and second level shifter circuits 92b, 92c implemented as voltage divider circuits. An example of the difference and threshold circuit 100, is also shown in Figure 5b. The difference and threshold circuit 100 shown in Figure 5b is unidirectional such that it is configured to determine the voltage difference if the second voltage at the second channel terminal 30 is less than the first voltage at the first channel terminal 28. Scaling (also called sizing) of the transistors of the difference and threshold circuit 100 may be tuned to set the comparison threshold (*Vₜₕ*) appropriately. In the example of Figure 5b, the comparison threshold (*Vₜₕ*) is determined such that the logic circuit 54 is configured to prevent the instruction signal 33 as the voltage difference between the first and second channel terminals 28, 30 exceeds the switch threshold.

In the example of Figure 5b, the difference and threshold circuit 100 may comprise first transistor 111, second transistor 113, third transistor 119, current mirror transistors 115, and current source transistors 117, 117a, 117b. A first current source transistor 117a is sized in comparison to the second current source transistor 117b, so the gate of the third transistor 119 will be 'high' until the voltage difference between the voltage at the gate of the first transistor 111 and the voltage at the gate of the second transistor 113 is less than the comparison threshold (*Vₜₕ*)*.*

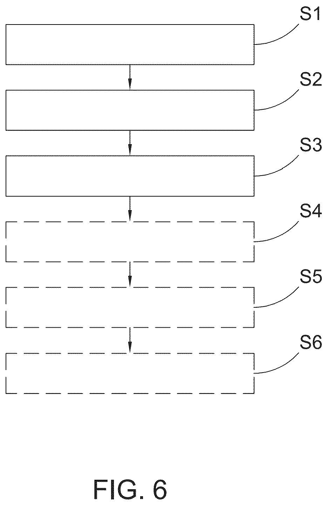

With reference to Figures 2, 4, 5a, 5b, the solid state switch device 23 may be operated in accordance with a method for setting the value of the control signal 32 as shown in Figure 6. The control signal 32 value (i.e., protection value, pass value) may determine the output signal 34 of the overvoltage protection circuit 24 for application to the control terminal 26 of a controllable switch 25. The control signal 32 is suitable for operating the controllable switch 25.

The method, as shown in Figure 6, to operate the controllable switch 25 may comprise the following steps:
S1: determining a voltage difference between a first voltage of the first channel terminal 28 of the controllable switch 25 and a second voltage of the second channel terminal 30 of the controllable switch 25.
S2: determining that the voltage difference is greater than or equal to a switch threshold.
S3: operate the controllable switch in the off-state in response to determining that the voltage difference is greater than or equal to a switch threshold. A control signal 32 may be set to a protection value to operate the controllable switch in the off-state in response to determining that the voltage difference is greater than or equal to a switch threshold. Specifically, the control signal 32 may be used to, when the voltage difference is greater than or equal to a switch threshold: prevent the controllable switch from switching to the on-state from the off-state of the controllable switch; and/or, control the controllable switch to switch to the off-state from the on-state of the controllable switch 25.

The method may comprise further one or more optional steps:
S4: receive an instruction signal 33 for controlling the state of the controllable switch 25 to either an off-state or an on-state.
S5: determining that the voltage difference is less than the switch threshold.
S6: control the state of the controllable switch with the instruction signal in response to determining that the voltage difference is less than the switch threshold. The control signal 32 may be set to a pass value, such that when the control signal 32 is a pass value the instruction signal 33 controls the state of the controllable switch 25.

Operating the controllable switch 25 in the off-state comprises: if the controllable switch 25 is already in the off-state, preventing the controllable switch from switching to the on-state; and/or, if the controllable switch is in the on-state, controlling the controllable switch 25 to switch to the off-state.

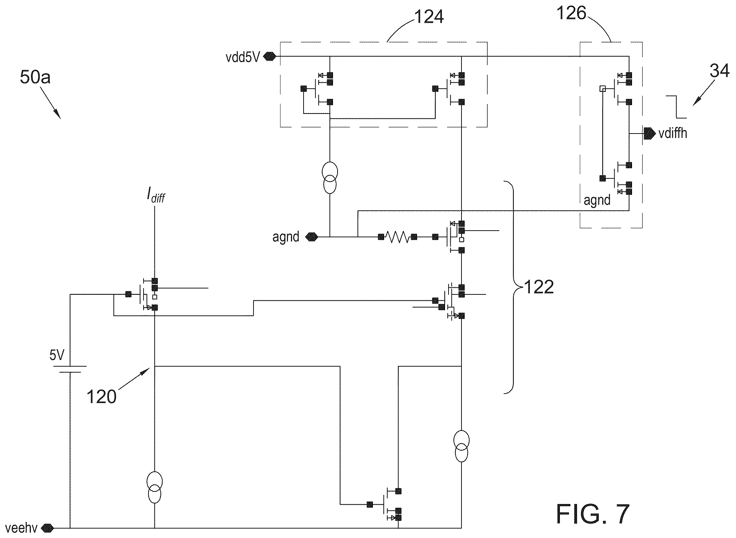

Figure 7 provides an alternative sub-circuit 50a to the sub-circuit 50 shown and described with reference to Figure 3. The alternative sub-circuit 50a receives the difference signal as a current (*I_{diff}*) and generates the output signal 34. The alternative sub-circuit 50a is arranged to compare the difference signal (*I_{diff}*) to a comparison threshold (*Vₜₕ*) to generate the control signal 32. The alternative sub-circuit 50a comprise a current comparator node 120, a level shifter 122, a current mirror 124, and an inverter 126.

### General

Each block of Figures 2 to 5b and 7 is shown and defined for explanatory purposes only, it would be well understood that the algorithm or function which each block represents may be implemented in a plurality of other ways so long as the functionality as described is present. For example, the blocks of any one of Figures 2 to 5b, and/or 7 may be combined and implemented as part of a circuit arrangement, on a single integrated circuit, processor, or computer, or implemented by a plurality of circuit arrangements, integrated circuits, processors, and/or computers.

In the example of Figure 4, the controllable switch 25 is shown to be distinct from the overvoltage protection circuit 24. In an alternative example, the overvoltage protection circuit 24 may comprise the controllable switch 25.

In an example, the controllable switch 25 may comprise a FET. The first channel terminal 28 may comprise a drain terminal of the FET. The switch capacitance of the controllable switch 25 may comprise a parasitic gate-source capacitor (Cgs) of the FET.

In an example, the controllable switch 25 is packaged with the overvoltage protection circuit 24. In an alternative example, the overvoltage protection circuit 24 may be provided separately/independently from a controllable switch 25, such that the overvoltage protection circuit 24 may be provided to many different controllable switches. Thus, the overvoltage protection circuit 24 is configured to be coupled (or is couplable) to: a control terminal (e.g., 11, 21, 11a, 26) of a controllable switch (e.g., 10, 18, 10a, 25); a first channel terminal (e.g., 12, 12a, 28) of the controllable switch (e.g., 10, 18, 10a, 25); and a second channel terminal (e.g., 14, 22, 14a, 30) of the controllable switch (e.g., 10, 18, 10a, 25). The overvoltage protection circuit (e.g., 24, 24a, 24b, 24c) is further configured to generate the control signal 32 based on to a received voltage difference between the first channel terminal of the controllable switch and the second channel terminal of the controllable switch.

Each of the current mirror components (e.g., 78a, 78b, 88a, 88b) may be any suitable component, such as one or more transistors, e.g., FET(s), e.g., MOSFET(s), etc.

As described above, the overvoltage protection circuit 24 is configured to set the control signal 32 to the protection value to operate the controllable switch 25 in the off-state in response to determining that the voltage difference is greater than or equal to the switch threshold. In an example, the control signal 32 may be set in response to determining that the voltage difference is greater than or equal to the switch threshold, via a comparison of *I_{diff}* or *V_{diff}* to a comparison threshold *Iₜₕ*, *Vₜₕ* respectively.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to."

The words "coupled" or "connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list.

It is to be understood that one or more features from one or more of the above-described embodiments may be combined with one or more features of one or more other ones of the above-described embodiments, so as to form further embodiments which are within the scope of the appended claims.

### NUMBERED CLAUSES

By way of non-limiting example, some aspects of the disclosure are set out in the following numbered clauses.

Numbered Clause 1. A solid state switch device, comprising:
a controllable switch comprising a control terminal, a first channel terminal, and a second channel terminal, and arranged to be switched between an off-state and an on-state, wherein in the on-state the switch allows a current to flow between the first channel terminal and the second channel terminal; and
an overvoltage protection circuit configured to:
   determine a voltage difference between a first voltage of the first channel terminal and a second voltage of the second channel terminal; and,
   setting a control signal to a protection value to operate the controllable switch in the off-state in response to determining that the voltage difference is greater than or equal to a switch threshold.

Numbered Clause 2. The solid state switch device of numbered clause 1, wherein the solid state switch device is configured to use the control signal to, when the voltage difference is greater than or equal to a switch threshold:
prevent the controllable switch from switching to the on-state from the off-state of the controllable switch; and/or,
control the controllable switch to switch to the off-state from the on-state of the controllable switch.

Numbered Clause 3. The solid state switch device of any one of numbered clauses 1 or 2, wherein the overvoltage protection circuit is configured to:
receive an instruction signal for controlling the state of the controllable switch to either an off-state or an on-state; and,
in response to determining that the voltage difference is less than the switch threshold, set the control signal to a pass value, such that when the control signal is a pass value the instruction signal controls the state of the controllable switch.

Numbered Clause 4. The solid state switch device of any preceding numbered clause, wherein the overvoltage protection circuit comprises:
a first buffer comprising an input and an output, wherein the input is electrically coupled to the first channel terminal; and
a second buffer comprising an input and an output, wherein the input is electrically coupled to the second channel terminal.

Numbered Clause 5. The solid state switch device of numbered clause 4, wherein the overvoltage protection circuit is arranged to generate a difference signal based on the output of the first buffer and the output of the second buffer, wherein the voltage difference is compared to the switch threshold by comparing the difference signal to a comparison threshold, wherein the comparison threshold has a predetermined relationship to the switch threshold.

Numbered Clause 6. The solid state switch device of numbered clause 5, wherein the difference signal is a current signal.

Numbered Clause 7. The solid state switch device of any one of numbered clauses 5 or 6, wherein the difference signal is proportional to the voltage difference between the first channel terminal and the second channel terminal.

Numbered Clause 8. The solid state switch device of any one of numbered clauses 5 to 7, wherein the overvoltage protection circuit further comprises a resistive component, wherein the output of the first buffer is coupled to a first terminal of the resistive element and, wherein the output of the second buffer is coupled to a second terminal of the resistive component.

Numbered Clause 9. The solid state switch device of numbered clause 8, wherein the resistive component is a resistor, wherein the output voltage of the first buffer is proportional to the input voltage of the first buffer, and wherein the output voltage of the second buffer is proportional to the input voltage of the second buffer.

Numbered Clause 10. The solid state switch device of any of numbered clauses 5 to 9, wherein the overvoltage protection circuit comprises:
a first current mirror arrangement configured to:
generate the difference signal based on the current flow between the output of the first buffer and the output of the second buffer.

Numbered Clause 11. The solid state switch device of numbered clause 10, wherein the first current mirror arrangement is arranged to have a gain less than or equal to unity gain.

Numbered Clause 12. The solid state switch device of any one of numbered clauses 10 or 11, wherein the first current mirror arrangement comprises a first current mirror component and a second current mirror component, wherein the first current mirror component is positioned between the output of the first buffer and the resistive component, wherein the second current mirror component is arranged to generate the difference signal based on the current flow through the first current mirror component.

Numbered Clause 13. The solid state switch device of any one of numbered clauses 10 to 12, wherein the solid state switch device is a bi-directional solid state switch, wherein the first current mirror arrangement is configured to generate the difference signal if a voltage at the first channel terminal is greater than the voltage at the second channel terminal, and wherein the overvoltage protection circuit further comprises:
a second current mirror arrangement configured to generate the difference signal if a voltage at the second channel terminal is greater than the voltage at the first channel terminal.

Numbered Clause 14. The solid state switch device of numbered clause 13, wherein the second current mirror arrangement comprises a third current mirror component and a fourth current mirror component, wherein the third current mirror component is positioned between the output of the second buffer and the resistive component.

Numbered Clause 15. The solid state switch device of numbered clause 14, wherein the fourth current mirror component is arranged to generate the difference signal based on the current flow through the third current mirror component.

Numbered Claus 16. The solid state switch device of any one of numbered clauses 1 to 15, wherein the difference signal is a voltage signal.

Numbered Clause 17. An overvoltage protection circuit configured to be coupled to: a control terminal of a controllable switch; a first channel terminal of the controllable switch; and a second channel terminal of the controllable switch, wherein the overvoltage protection circuit configured to:
determine a voltage difference between the first channel terminal and the second channel terminal; and,
generate a control signal for setting the controllable switch to operate in the off-state, in response to determining that the voltage difference is greater than or equal to a switch threshold.

Numbered Clause 18. A method of operating a controllable switch for overvoltage protection, the controllable switch comprising a control terminal, a first channel terminal, and a second channel terminal, and arranged to be switched between an off-state and an on-state, wherein in the on-state the switch allows a current to flow between the first channel terminal and the second channel terminal, the method comprising:
determining a voltage difference between a first voltage of the first channel terminal and a second voltage of the second channel terminal;
determining that the voltage difference is greater than or equal to a switch threshold; and,
operate the controllable switch in the off-state in response to determining that the voltage difference is greater than or equal to a switch threshold.

Numbered Clause 19. The method of numbered clause 18, further comprising, when the voltage difference is greater than or equal to a switch threshold:
preventing the controllable switch from switching to the on-state from the off-state of the controllable switch; and/or,
controlling the controllable switch to switch to the off-state from the on-state of the controllable switch.

Numbered Clause 20. The method of any one of numbered clauses 18 or 19, further comprising:
receiving an instruction signal for controlling the state of the controllable switch to either an off-state or an on-state; and,
when the voltage difference is less than the switch threshold, controlling the state of the controllable switch to either an off-state or an on-state in accordance with the instruction signal.

## Claims

1. A solid state switch device, comprising:
a controllable switch comprising a control terminal, a first channel terminal, and a second channel terminal, the control terminal operable to control switching of the controllable switch between an off-state and an on-state, wherein in the on-state the switch allows a current to flow between the first channel terminal and the second channel terminal; and
an overvoltage protection circuit configured to:
determine a voltage difference between a first voltage of the first channel terminal and a second voltage of the second channel terminal; and
set a control signal to a protection value to operate the controllable switch in the off-state in response to determining that the voltage difference is greater than or equal to a switch threshold.

2. The solid state switch device of claim 1, wherein the solid state switch device is configured to use the control signal to, when the voltage difference is greater than or equal to a switch threshold:
prevent the controllable switch from switching to the on-state from the off-state of the controllable switch; and/or,
control the controllable switch to switch to the off-state from the on-state of the controllable switch.

3. The solid state switch device of any one of claims 1 or 2, wherein the overvoltage protection circuit is configured to:
receive an instruction signal for controlling the state of the controllable switch to either an off-state or an on-state; and,
in response to determining that the voltage difference is less than the switch threshold, set the control signal to a pass value, such that when the control signal is a pass value the instruction signal controls the state of the controllable switch.

4. The solid state switch device of any preceding claim, wherein the overvoltage protection circuit comprises:
a first buffer comprising an input and an output, wherein the input is electrically coupled to the first channel terminal; and
a second buffer comprising an input and an output, wherein the input of the second buffer is electrically coupled to the second channel terminal.

5. The solid state switch device of claim 4, wherein the overvoltage protection circuit is arranged to generate a difference signal based on the output of the first buffer and the output of the second buffer, wherein the voltage difference is compared to the switch threshold by comparing the difference signal to a comparison threshold, wherein the comparison threshold has a predetermined relationship to the switch threshold.

6. The solid state switch device of claim 5, wherein the difference signal is a current signal.

7. The solid state switch device of any one of claims 5 to 6, wherein the difference signal is proportional to the voltage difference between the first channel terminal and the second channel terminal.

8. The solid state switch device of any one of claims 5 to 7, wherein the overvoltage protection circuit further comprises a resistive component, wherein the output of the first buffer is coupled to a first terminal of the resistive component and, wherein the output of the second buffer is coupled to a second terminal of the resistive component.

9. The solid state switch device of claim 8, wherein the resistive component is a resistor, wherein an output voltage of the first buffer is proportional to an input voltage of the first buffer, and wherein an output voltage of the second buffer is proportional to an input voltage of the second buffer.

10. The solid state switch device of any one of claims 5 to 9, wherein the overvoltage protection circuit comprises:
a first current mirror arrangement configured to generate the difference signal based on a current flow between the output of the first buffer and the output of the second buffer, and optionally, the first current mirror arrangement is arranged to have a gain less than or equal to unity gain.

11. The solid state switch device of claim 10, wherein the first current mirror arrangement comprises a first current mirror component and a second current mirror component, wherein the first current mirror component is positioned between the output of the first buffer and the resistive component, wherein the second current mirror component is arranged to generate the difference signal based on a current flow through the first current mirror component.

12. The solid state switch device of any one of claims 10 or 11, wherein the solid state switch device is implemented as a bi-directional solid state switch, wherein the first current mirror arrangement is configured to generate the difference signal when a voltage at the first channel terminal is greater than the voltage at the second channel terminal, and wherein the overvoltage protection circuit further comprises:
a second current mirror arrangement configured to generate the difference signal when a voltage at the second channel terminal is greater than the voltage at the first channel terminal.

13. The solid state switch device of claim 12, wherein the second current mirror arrangement comprises a third current mirror component and a fourth current mirror component, wherein the third current mirror component is positioned between the output of the second buffer and the resistive component,
and optionally, the fourth current mirror component is arranged to generate the difference signal based on the current flow through the third current mirror component.

14. An overvoltage protection circuit configured to be coupled to a control terminal of a controllable switch a first channel terminal of the controllable switch, and a second channel terminal of the controllable switch, the control terminal operable to control switching of the controllable switch between an off-state and an on-state, wherein the overvoltage protection circuit is configured to:
determine a voltage difference between the first channel terminal and the second channel terminal; and,
generate a control signal for setting the controllable switch to operate in the off-state, in response to determining that the voltage difference is greater than or equal to a switch threshold.

15. A method of operating a controllable switch for overvoltage protection, the controllable switch comprising a control terminal, a first channel terminal, and a second channel terminal, the control terminal operable to control switching of the controllable switch between an off-state and an on-state, wherein in the on-state the switch allows a current to flow between the first channel terminal and the second channel terminal, the method comprising:
determining a voltage difference between a first voltage of the first channel terminal and a second voltage of the second channel terminal;
determining that the voltage difference is greater than or equal to a switch threshold; and
operate the controllable switch in the off-state in response to determining that the voltage difference is greater than or equal to a switch threshold.
